Europäisches Patentamt

European Patent Office

Office européen des brevets

(19)

(11) Publication number : **0 499 403 A2**

(12) **EUROPEAN PATENT APPLICATION**

(21) Application number : **92301000.3**

(22) Date of filing : **06.02.92**

(51) Int. Cl.$^5$ : **H01L 29/08, H01L 29/73, H01L 21/331**

(30) Priority : **13.02.91 JP 19602/91**

(43) Date of publication of application :
**19.08.92 Bulletin 92/34**

(84) Designated Contracting States :
**DE FR GB**

(71) Applicant : **NEC CORPORATION**
**7-1, Shiba 5-chome Minato-ku**
**Tokyo 108-01 (JP)**

(72) Inventor : **Kikuchi, Hiroaki, c/o NEC**
**Corporation**
**7-1 Shiba 5-chome**
**Minato-ku, Tokyo 108-01 (JP)**

(74) Representative : **Abnett, Richard Charles et al**
**REDDIE & GROSE 16 Theobalds Road**
**London WC1X 8PL (GB)**

(54) **Silicon bipolar transistor and method of fabricating the same.**

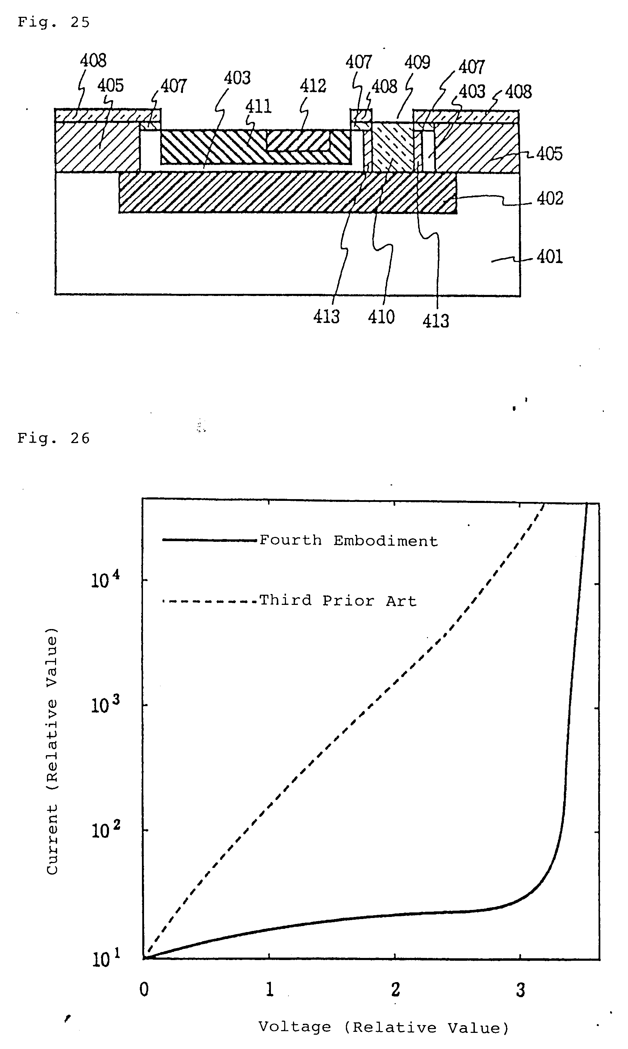

(57) In an npn silicon bipolar transistor, a hole (109) is formed only in that portion of an n-type epitaxial layer (103) formed on an n$^+$-type buried layer (102) where an n$^+$-type collector region (110) is to be formed, and this specific portion of the n-type epitaxial layer is made thinner. A p-type base region (111) and n$^+$-type emitter region (112) are then formed. The hole (409 ; Fig. 25) may be lined with an insulating film (413), and silicon grown in the hole and made n$^+$-type to form the n$^+$-type collector region (410). The resistance of the n$^+$-type collector region can be lower without causing misfit dislocation in the n$^+$-type collector region, thus providing a high-speed npn silicon bipolar transistor with a suppressed leak current.

Fig. 13

EP 0 499 403 A2

## BACKGROUND OF THE INVENTION

Field of the Invention

The present invention relates to a semiconductor device and a method of fabricating the same. More particularly, the present invention pertains to the structure of an $n^+$-type collector region in a silicon bipolar transistor having an npn junction, and a method of fabricating this transistor.

Description of the Related Art

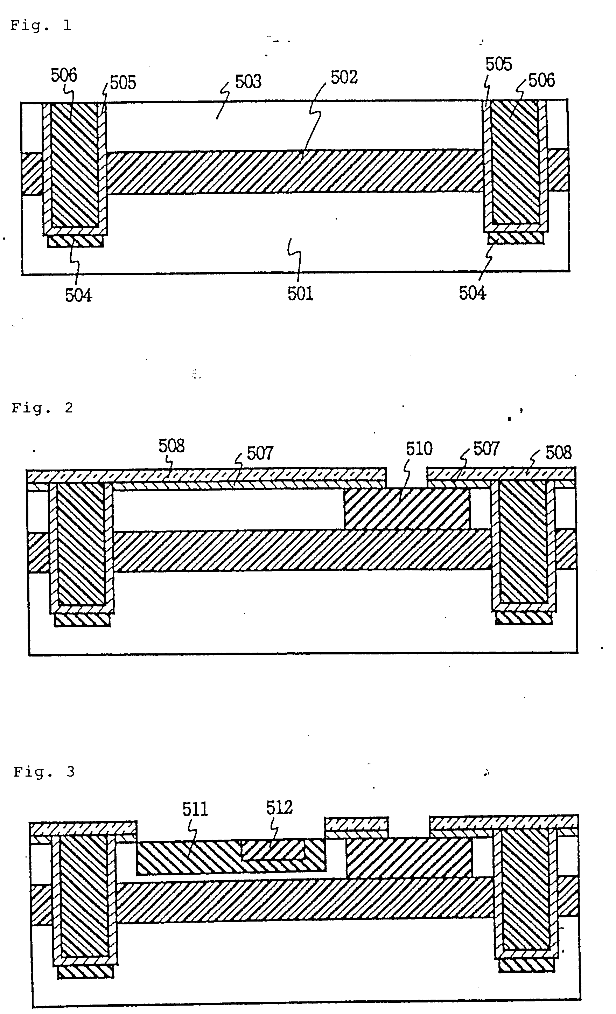

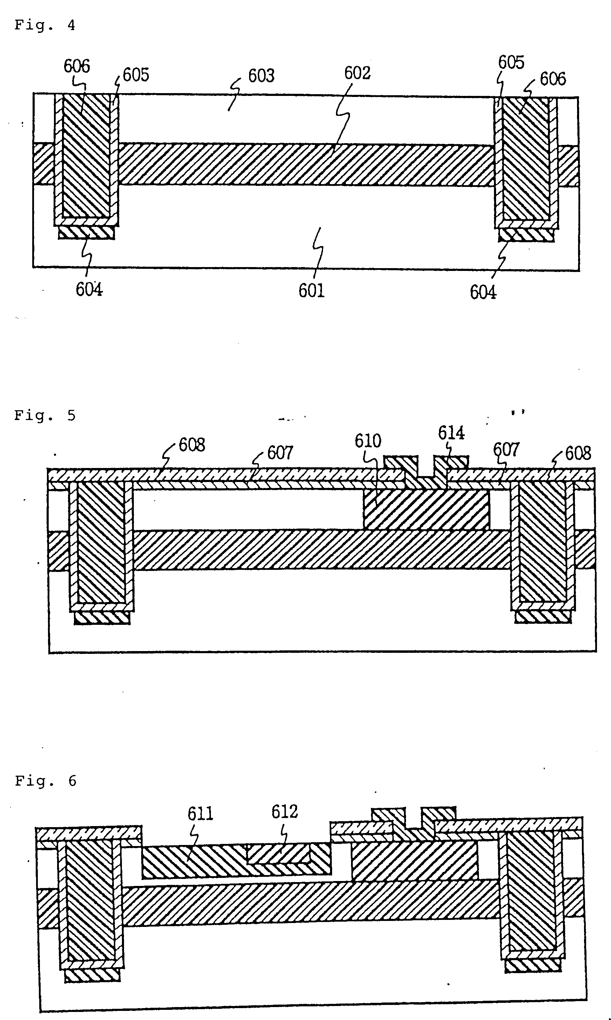

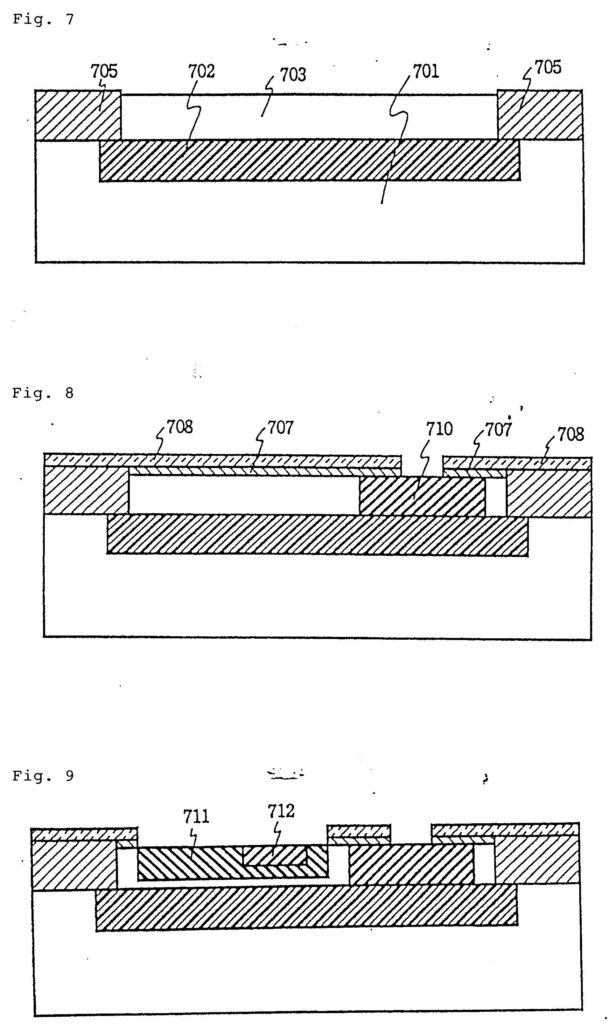

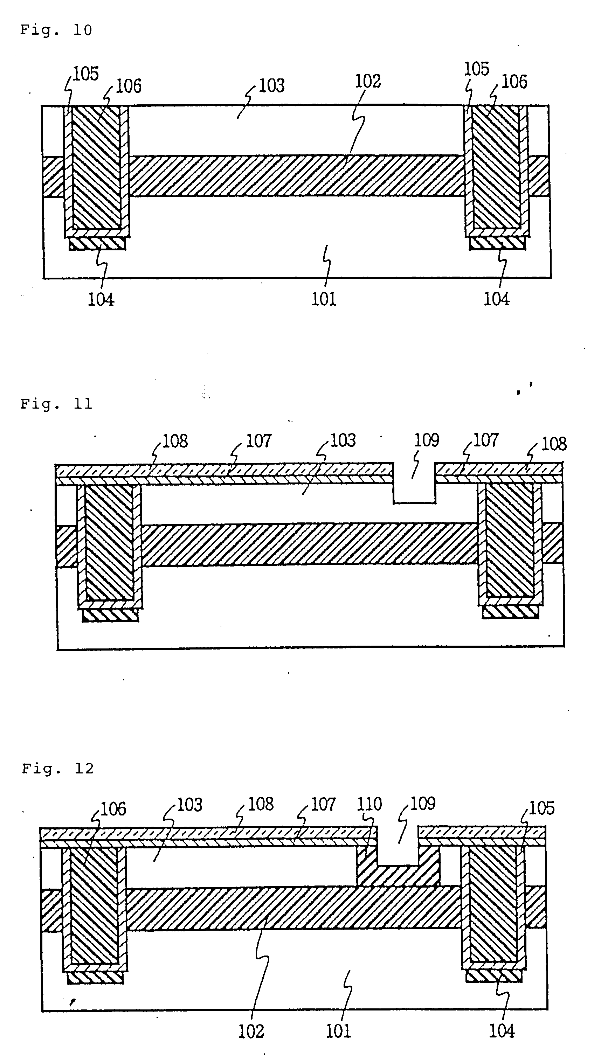

A first example (hereafter referred to as "first prior art") of the structure of a conventional silicon bipolar transistor with an npn junction and a conventional method of fabricating this transistor will be explained referring to vertical cross sections in Figs. 1 to 3 showing the step-by-step fabricating procedures.

An $n^+$-type buried layer 502 is formed on a p-type silicon substrate 501, with an n-type epitaxial layer 503 of about 1 μm thick formed on the layer 502. Then, a trench is formed so that it penetrates the n-type epitaxial layer 503 and the $n^+$-type buried layer 502. At the bottom of the trench a $p^+$-type region 504 is formed to serve as a channel stopper. A silicon oxide film 505 is formed on the surface of the trench by thermal oxidation, and then a polycrystalline silicon 506 is buried in the trench, thus providing a device-isolating region (see Fig. 1).

A silicon oxide film 507 and a silicon nitride film 508 are formed on the resultant structure by thermal oxidation and the CVD method, respectively. Those regions of the silicon nitride film 508 and the silicon oxide film 507 on which an $n^+$-type collector region is to be formed are etched away in order, forming an opening. With the silicon nitride film 508 as a mask, phosphorus is thermally diffused to form an $n^+$-type collector region 510 (see Fig. 2). This $n^+$-type collector region 510 extends wide from the opening in a transverse direction.

Those regions of the silicon nitride film 508 and the silicon oxide film 507 on which a p-type base region 511 is to be formed are sequentially etched away in order, forming an opening. After the p-type base region 511 is formed, an $n^+$-type emitter region 512 is provided, thus completing a bipolar transistor (see Fig. 3).

A second example (hereafter referred to as "second prior art") of the structure of a conventional silicon bipolar transistor with an npn junction and a conventional method of fabricating this transistor will be explained referring to vertical cross sections in Figs. 4 to 6 showing the step-by-step fabricating procedures.

An $n^+$-type buried layer 602 is formed on a p-type silicon substrate 601, with an n-type epitaxial layer 603 of about 1 μm thick formed on the layer 602. Then, a trench is formed so that it penetrates the n-type epitaxial layer 603 and the $n^+$-type buried layer 602. At the bottom of the trench a $p^+$-type region 604 is formed to serve as a channel stopper. A silicon oxide film 605 is formed on the surface of the trench by thermal oxidation, and then a polycrystalline silicon 606 is buried in the trench, thus providing a device-isolating region (see Fig. 4).

A silicon oxide film 607 and a silicon nitride film 608 are formed on the resultant structure by thermal oxidation and the CVD method, respectively. Those regions of the silicon nitride film 608 and the silicon oxide film 607 on which an $n^+$-type collector region is to be formed are etched away in order, forming an opening. Then, an $n^+$-type polycrystalline silicon film 614 is formed over the opening. An n-type impurity is thermally diffused from the polycrystalline silicon film 614 to form an $n^+$-type collector region 610 (see Fig. 5). This $n^+$-type collector region 610 extends wide from the opening in a transverse direction.

Those regions of the silicon nitride film 608 and the silicon oxide film 607 on which a p-type base region 611 is to be formed are sequentially etched away in order, forming an opening. After the p-type base region 611 is formed, an $n^+$-type emitter region 612 is provided, thus completing a bipolar transistor (see Fig. 6).

A third example (hereafter referred to as "third prior art") of the structure of a conventional silicon bipolar transistor with an npn junction and a conventional method of fabricating this transistor will be explained referring to vertical cross sections in Figs. 7 to 9 showing the step-by-step fabricating procedures.

An $n^+$-type buried layer 702 is selectively formed on a p-type silicon substrate 701, with an n-type epitaxial layer 703 of about 1 μm thick formed on the layer 702. Then, the n-type epitaxial layer 703 is selectively oxidized, providing a silicon oxide film 705 which isolates a device (see Fig. 7).

A silicon oxide film 707 and a silicon nitride film 708 are formed on the resultant structure by thermal oxidation and the CVD method, respectively. Those regions of the silicon nitride film 708 and the silicon oxide film 707 on which an $n^+$-type collector region is to be formed are etched away in order, forming an opening. With the silicon nitride film 708 as a mask, phosphorus is thermally diffused to form an $n^+$-type collector region 710 (see Fig. 8). This $n^+$-type collector region 710 extends wide from the opening in a transverse direction.

Those regions of the silicon nitride film 708 and the silicon oxide film 707 on which a p-type base region 711 is to be formed are sequentially etched away in order, forming an opening. After the p-type base region 711 is formed, an $n^+$-type emitter region 712 is provided, thus completing a bipolar transistor (see Fig. 9).

Recently, there has been a demand for lower resistance of an $n^+$-type collector region in search of higher speed and higher integration of bipolar transistors. If $P_2O_5$ is diffused at 1000°C for 15 minutes on an n-type epitaxial layer of about 1-$\mu$m thick to form an $n^+$-type collector region, the concentration of phosphorus in this region will be $3 \times 10^{22}/cm^3$, which decreases the resistance. With such a high phosphorus concentration, however, misfit dislocation occurs as reported in Journal of Applied Physics, Vol. 38, pp. 81-87, 1967. The misfit dislocation, if penetrating the emitter-base junction of the bipolar transistor, may cause a junction leak. Conventionally, the concentration of phosphorus to be diffused in the collector region has therefore been set to the value where misfit dislocation will not occur.

According to the above-described conventional semiconductor devices and conventional fabrication methods, the $n^+$-type collector region is formed by a diffusion layer that reaches the $n^+$-type buried layer from the surface of the thick n-type epitaxial layer. Lowering the resistance of the $n^+$-type collector region therefore increases the impurity concentration on the top surface of the $n^+$-type collector region, causing a misfit dislocation therefrom. The conventional semiconductor devices have therefore been designed not to have a high impurity concentration of the $n^+$-type collector region, which greatly restricts the high-speed operation of the semiconductor devices.

## SUMMARY OF THE INVENTION

It is therefore an object of the present invention to provide a semiconductor device which will not cause misfit dislocation, and a method of fabricating the same.

To achieve this object, according to one aspect of a semiconductor device and a method of fabricating the same embodying the present invention to provide an $n^+$-type collector region in an npn silicon bipolar transistor and a method of fabricating the transistor, only that portion of an n-type epitaxial layer on a surface of an $n^+$-type buried layer where the $n^+$-type collector region is to be formed is made thinner.

According to another aspect of a semiconductor device and a method of fabricating the same embodying the present invention, a hole reaching an $n^+$-type buried layer is formed in that portion of an n-type epitaxial layer on the surface of the $n^+$-type buried layer where an $n^+$-type collector region is to be formed, an insulating film is formed as a side wall on the side surface of the hole, and silicon is selectively grown in the hole and made an $n^+$ type, thereby providing the $n^+$-type collector region.

## BRIEF DESCRIPTION OF THE DRAWINGS

Fig. 1 is a vertical cross section of one step in a semiconductor device fabrication for explaining a first prior art;

Fig. 2 is a vertical cross section of the next step in the semiconductor device fabrication for explaining the first prior art;

Fig. 3 is a vertical cross section of the final step in the semiconductor device fabrication for explaining the first prior art;

Fig. 4 is a vertical cross section of one step in a semiconductor device fabrication for explaining a second prior art;

Fig. 5 is a vertical cross section of the next step in the semiconductor device fabrication for explaining the second prior art;

Fig. 6 is a vertical cross section of the final step in the semiconductor device fabrication for explaining the second prior art;

Fig. 7 is a vertical cross section of one step in a semiconductor device fabrication for explaining a third prior art;

Fig. 8 is a vertical cross section of the next step in the semiconductor device fabrication for explaining the third prior art;

Fig. 9 is a vertical cross section of the final step in the semiconductor device fabrication for explaining the third prior art;

Fig. 10 is a vertical cross section of one step in a semiconductor device fabrication for explaining a first embodiment of the present invention;

Fig. 11 is a vertical cross section of the next step in the semiconductor device fabrication for explaining the first embodiment of the present invention;

Fig. 12 is a vertical cross section of the following step in the semiconductor device fabrication for explaining the first embodiment of the present invention;

Fig. 13 is a vertical cross sectional view of the final step in the semiconductor device fabrication for explaining the first embodiment of the present invention;

Fig. 14 is a graph showing a current-voltage characteristic for explaining the effect of the first embodiment of the present invention;

Fig. 15 is a vertical cross section of one step in a semiconductor device fabrication for explaining a second embodiment of the present invention;

Fig. 16 is a vertical cross section of the next step in the semiconductor device fabrication for explaining the second embodiment of the present invention;

Fig. 17 is a vertical cross section of the following step in the semiconductor device fabrication for explaining the second embodiment of the present invention;

Fig. 18 is a vertical cross section of the final step in the semiconductor device fabrication for explaining the second embodiment of the present invention;

Fig. 19 is a graph showing a current-voltage characteristic for explaining the effect of the second embodiment of the present invention;

Fig. 20 is a vertical cross section of one step in a semiconductor device fabrication for explaining a third embodiment of the present invention;

Fig. 21 is a vertical cross section of the next step in the semiconductor device fabrication for explaining the third embodiment of the present invention;

Fig. 22 is a vertical cross section of the following step in the semiconductor device fabrication for explaining the third embodiment of the present invention;

Fig. 23 is a vertical cross section of the final step in the semiconductor device fabrication for explaining the third embodiment of the present invention;

Fig. 24 is a graph showing a current-voltage characteristic for explaining the effect of the third embodiment of the present invention;

Fig. 25 is a vertical cross section for explaining a fourth embodiment of the present invention; and

Fig. 26 is a graph showing a current-voltage characteristic for explaining the effect of the fourth embodiment of the present invention.

## DETAILED DESCRIPTION OF THE PREFERRED EMBODIMENTS

Preferred embodiments of the present invention will now be described referring to the accompanying drawings. Figs. 10 to 13 are vertical cross-sectional views showing the step-by-step fabrication of a semiconductor device for explaining a first embodiment of the present invention. In this embodiment, an $n^+$-type collector region 110, which reaches an $n^+$-type buried layer 102, is formed at the bottom of a hole 109 made in the top surface of an n-type epitaxial layer 103.

Arsenic (As) is doped about $5 \times 10^{19}/cm^3$ in part of the top surface of a p-type silicon substrate 101 with a specific resistance of 10 $\Omega \cdot cm$, providing the $n^+$-type buried layer 102. Further, a normal n-type epitaxial layer 103 of about 1 $\mu m$ thick is formed on the layer 102. Then, a trench is formed so that it penetrates the n-type epitaxial layer 103 and the $n^+$-type buried layer 102. At the bottom of the trench a $p^+$-type region 104 is formed to serve as a channel stopper. After a silicon oxide film 105 is formed on the surface of the trench by thermal oxidation, a polycrystalline silicon 106 will be buried in the trench, thus providing a device-isolating region (see Fig. 10).

A silicon oxide film 107 and a silicon nitride film 108 are formed on the resultant structure by thermal oxidation and the CVD method, respectively. Those regions of the silicon nitride film 108 and the silicon oxide film 107 on which an $n^+$-type collector region is to be formed are etched away in order, and the n-type epitaxial layer 103 is etched about 0.5 $\mu m$, forming an opening 109 (Fig. 11).

Then, 1000 ppm of $POCl_3$ is diffused at 950°C for six minutes, using the silicon nitride film 108 as a diffusion mask and a gas mixture of nitrogen and oxygen as a carrier gas. Phosphorus is doped in the resultant structure at 1000°C for 20 minutes in the atmosphere of nitrogen, thus providing an $n^+$-type collector region 110 (see Fig. 12).

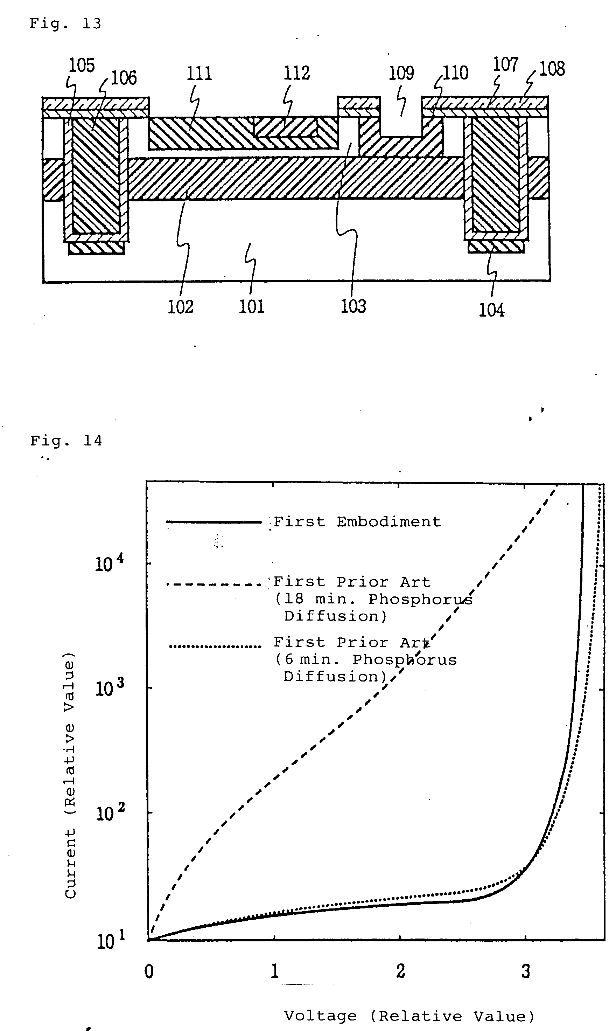

Those regions of the silicon nitride film 108 and the silicon oxide film 107 on which a p-type base region 111 is to be formed are sequentially etched away, forming an opening. After the p-type base region 111 is formed by, for example, ion implantation, an $n^+$-type emitter region 112 will be formed by ion implantation, for example, thus completing a bipolar transistor (see Fig. 13).

Controls were produced according to the first prior art shown in Figs. 1 to 3 to be compared with the first embodiment. The controls of the first prior art were subjected to phosphorus diffusion (using 1000 ppm of $POCl_3$) at 950°C for two different periods of time, 6 minutes and 18 minutes.

The occurrence of dislocations in the $n^+$-type collector region was evaluated with a transmission electron microscope. In the case of the first prior art subjected to 18-minute phosphorus diffusion, 26 dislocations occurred on the average in a 4-$\mu m$ square of the $n^+$-type collector region, and two of those dislocations on the average were extended to the base and emitter regions. On the other hand, no dislocations appeared in the first prior art subjected to 6-minute phosphorus diffusion and this embodiment.

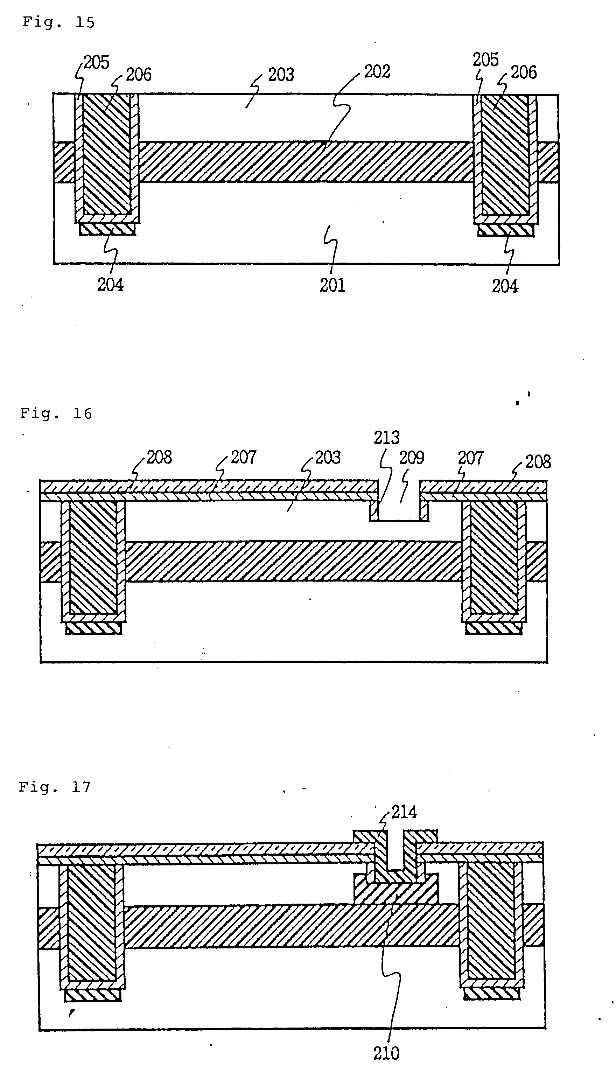

Then, the current-voltage characteristic was measured and the results of the measurement are given in Fig. 15. The first prior art subjected to 6-minute phosphorus diffusion has about the same leak current as this embodiment, which is significantly lower than the leak current of the first prior art subjected to 18-minute phosphorus diffusion.

Subsequently, the cut-off frequency representing the high-speed operational performance of the bipolar transistor was measured. The first prior art subjected to 18-minute phosphorus diffusion and this embodiment showed a cut-off frequency 1.3 times higher than that of the first prior art subjected to 6-minute phosphorus diffusion. It is obvious from the comparison results that this embodiment can lower the resistance of the $n^+$-type collector region without causing any misfit dislocation in the $n^+$-type collector region. This embodiment can also make the gap between the $n^+$-type collector region and the p-type base region narrower than the prior art (by about 0.5 $\mu m$).

Figs. 15 to 18 are vertical cross-sectional views showing the step-by-step fabrication of a semiconductor device for explaining a second embodiment of the present invention. In this embodiment, an $n^+$-type collector region 210, which reaches an $n^+$-type buried layer 202, is formed at the bottom of a hole 209 made in the top surface of an n-type epitaxial layer 203, a side wall consisting of a silicon oxide film 213 is formed on the side surface of the hole 209, and an $n^+$-type collector region 210 is formed by impurity diffusion from an $n^+$-type polycrystalline silicon film 214 formed over the hole 209.

Arsenic (As) is doped about $5 \times 10^{19}/cm^3$ in part of the top surface of a p-type silicon substrate 201 with a specific resistance of 10 $\Omega \cdot cm$, providing the $n^+$-type buried layer 202. Further, a normal n-type epitaxial layer 203 of about 1 $\mu m$ thick is formed on the layer 202. Then, a trench is formed so that it penetrates the n-type epitaxial layer 203 and the $n^+$-type buried layer 202. At the bottom of the trench a $p^+$-type region 204 is formed to serve as a channel stopper. After a silicon oxide film 205 is formed on the surface of the trench by thermal oxidation, a polycrystalline silicon 206 will be buried in the trench, thus providing a device-isolating region (see Fig. 15).

A silicon oxide film 207 and a silicon nitride film 208 are formed on the resultant structure by thermal oxidation and the CVD method, respectively. Those regions of the silicon nitride film 208 and the silicon oxide film 207 on which an $n^+$-type collector region is to be formed are etched away in order, and the n-type epitaxial layer 203 is etched about 0.5 $\mu m$, forming an opening 209. After the surface of the hole 209 is thermally oxidized, anisotropic etching is performed to remove a thermally oxidized film at the bottom of the hole 209, so that a silicon oxide film 213 as a side wall may only remain on the side surface of the hole 209 (see Fig. 16).

A polycrystalline silicon film is deposited on the entire surface of the resultant structure and is left remaining only on the spot for covering the hole 209 by a normal, finely processing technique. Further, 3000 ppm of $POCl_3$ is diffused at 950°C for seven minutes, using a gas mixture of nitrogen and oxygen as a carrier gas, so that the polycrystalline silicon film is converted into an $n^+$-type polycrystalline silicon film 214. Phosphorus is doped through the $n^+$-type polycrystalline silicon film 214 by thermal treatment at 1000°C for 20 minutes in the atmosphere of nitrogen, thus providing an $n^+$-type collector region 210 (see Fig. 17).

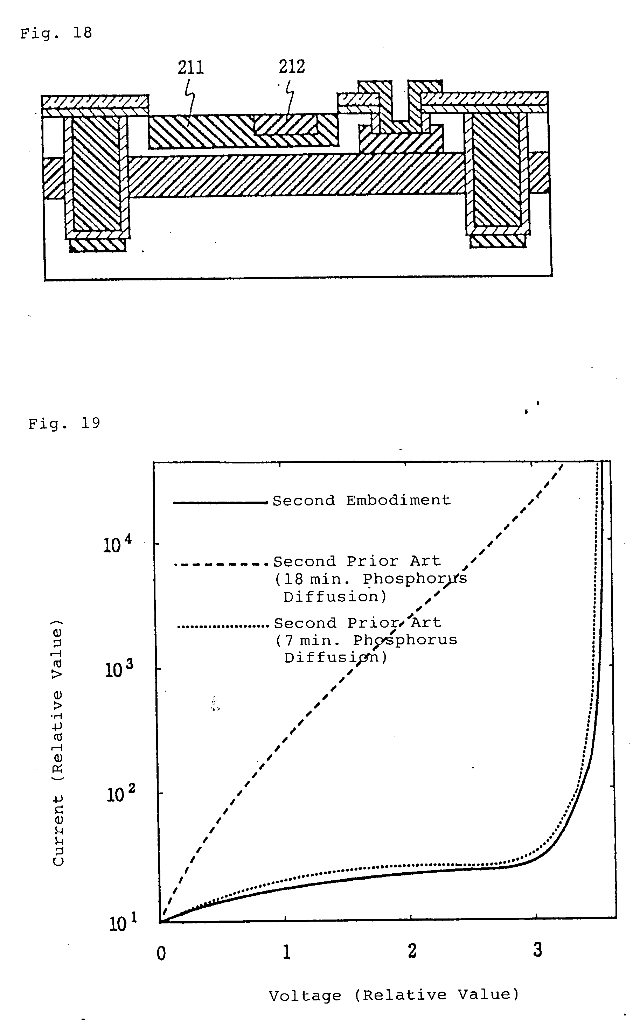

Those regions of the silicon nitride film 208 and the silicon oxide film 207 on which a p-type base region 211 is to be formed are sequentially etched away, forming an opening. After the p-type base region 211 is formed by, for example, ion implantation, an $n^+$-type emitter region 212 is formed by ion implantation, for example, thus completing a bipolar transistor (see Fig. 18).

Controls were produced according to the second prior art shown in Figs. 4 to 6 to be compared with the second embodiment. The controls of the second prior art were subjected to phosphorus diffusion (using 3000 ppm of $POCl_3$) at 950°C for two different periods of time, 7 minutes and 18 minutes.

The occurrence of dislocations in the $n^+$-type collector region was evaluated with a transmission electron microscope. In the case of the second prior art subjected to 18-minute phosphorus diffusion, 24 dislocations occurred on the average in a 4-$\mu m$ square of the $n^+$-type collector region, and two of those dislocations on the average were extended to the base and emitter regions. On the other hand, no dislocations appeared in the second prior art subjected to 7-minute phosphorus diffusion and this embodiment.

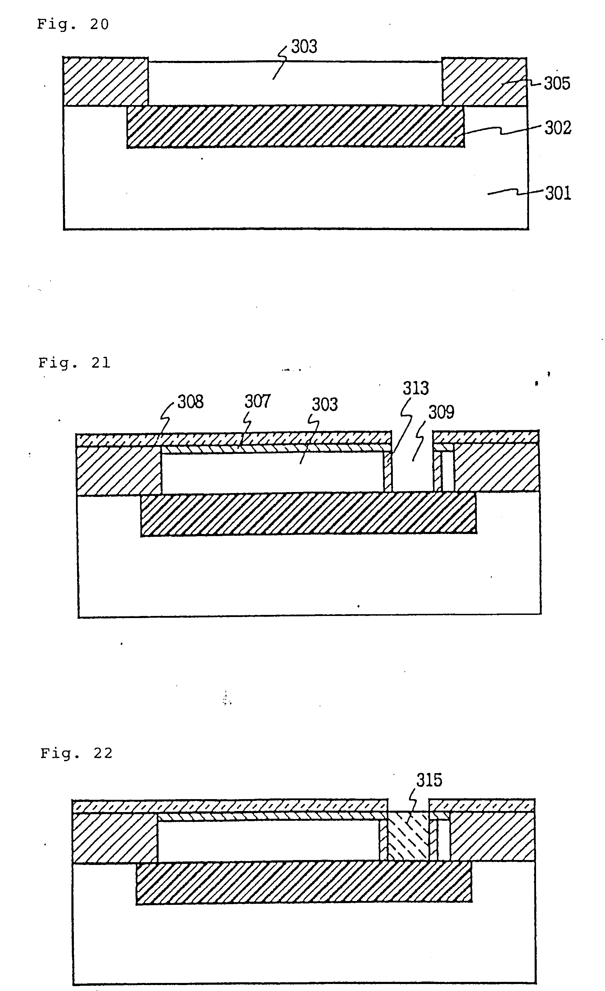

Then, the current-voltage characteristic was measured and the results of the measurement are given in Fig. 19. The second prior art subjected to 7-minute phosphorus diffusion has about the same leak current as this embodiment, which is significantly lower than the leak current of the second prior art subjected to 18-minute phosphorus diffusion.

Subsequently, the cut-off frequency representing the high-speed operational performance of the bipolar transistor was measured. The second prior art subjected to 18-minute phosphorus diffusion and this embodiment showed a cut-off frequency 1.3 times higher than that of the second prior art subjected to 7-minute phosphorus diffusion. It is obvious from the comparison results that this embodiment can lower the resistance of the $n^+$-type collector region without causing any misfit dislocation in the $n^+$-type collector region. This embodiment can also make the gap between the $n^+$-type collector region and the p-type base region narrower than the prior art (by about 0.5 $\mu m$).

Figs. 20 to 23 are vertical cross-sectional views showing the step-by-step fabrication of a semiconductor device for explaining a third embodiment of the present invention. In this embodiment, a hole 309, which reaches an $n^+$-type buried layer 302, is formed in the top surface of an n-type epitaxial layer 303. A side wall consisting of a silicon oxide film 313 is then formed on the side surface of the hole 309. An epitaxial film 315 of selectively grown single crystalline silicon is further formed inside the hole 309, and then an $n^+$-type collector region 310 is formed by impurity diffusion from the epitaxial film 315.

Arsenic (As) is doped about $5 \times 10^{19}/cm^3$ in part of the top surface of a p-type silicon substrate 301 with a specific resistance of 10 $\Omega \cdot cm$, selectively providing the $n^+$-type buried layer 302. Further, the n-type epitaxial layer 303 of about 1 $\mu m$ thick is formed on the top surface of the layer 302. Then, the n-type epitaxial layer 303 is selectively oxidized, thus providing a device-isolating silicon oxide film 305 (see Fig. 20).

A silicon oxide film 307 and a silicon nitride film 308 are formed on the resultant structure by thermal oxidation and the CVD method, respectively. Those regions of the silicon nitride film 308 and the silicon oxide film 307 on which an $n^+$-type collector region is to be formed are etched away in order, forming an opening 309 which reaches the n+-type buried layer 302. After a thermally oxidized film of about 0.1 μm is formed on the surface of the hole 309, anisotropic etching will be performed to remove the thermally oxidized film at the bottom of the hole 309, so that the silicon oxide film 313 may only remain as a side wall on the side surface of the hole 309 (Fig. 21).

The hole 309 is filled with a silicon epitaxial film 315 by the selective epitaxial growth (see Fig. 22). With this method, a gas mixture of dichlorosilane (SiH₂Cl₂), hydrogen chloride (HCl) and hydrogen (H₂) is used as a supply gas at the growth temperature of 950°C and the pressure of 50 Torr.

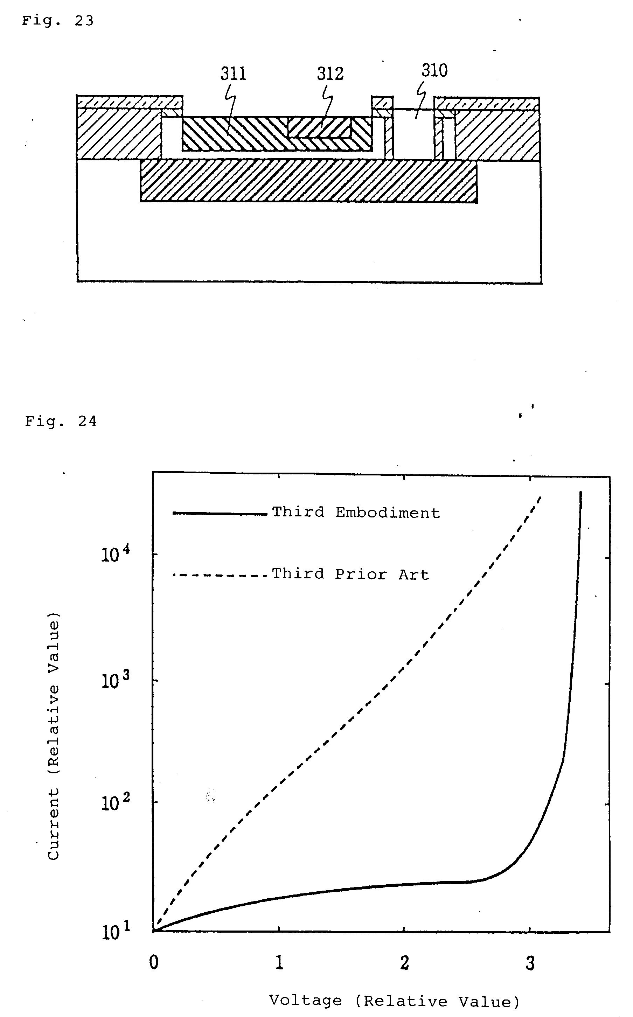

Then, 1000 ppm of POCl₃ is diffused at 950°C for 20 minutes, using the silicon nitride film 308 as a diffusion mask and a gas mixture of nitrogen and oxygen as a carrier gas, so that the epitaxial film 315 may be converted into the n+-type collector region 310. Phosphorus is doped in the resultant structure at 1000°C for 20 minutes in the atmosphere of nitrogen. Then, those regions of the silicon nitride film 308 and the silicon oxide film 307 on which a p-type base region 311 is to be formed are sequentially etched away, forming an opening. After the p-type base region 311 is formed by, for example, ion implantation, an n+-type emitter region 312 is formed by ion implantation, for example, thus completing a bipolar transistor (see Fig. 23).

Controls were produced according to the third prior art shown in Figs. 7 to 9 to be compared with the third embodiment. The controls of the third prior art were subjected to phosphorus diffusion (using POCl₃ of 1000 ppm) at 950°C for 20 minutes.

The occurrence of dislocations in the n+-type collector region was evaluated with a transmission electron microscope. In the third prior art, 31 dislocations occurred on the average in a 4-μm square of the n+-type collector region, and two of those dislocations on the average were extended to the base and emitter regions. On the other hand, no dislocations reaching the base and emitter regions appeared in this embodiment, though almost the same number of dislocations as the third prior art occurred. This is because the n+-type collector region 310 is isolated from the n-type epitaxial layer 303 by the silicon oxide film 313.

Then, the current-voltage characteristic was measured and the results of the measurement are given in Fig. 24. The leak current of this embodiment is significantly lower than the leak current of the third prior art.

It is apparent from the comparison results that this embodiment can lower the resistance of the n+-type collector region without considering any misfit dislocation in the n+-type collector region. Further, this embodiment can make the gap between the n+-type collector region and the p-type base region even narrower than the first and second embodiments.

Fig. 25 is a vertical cross section for explaining a fourth embodiment of the present invention. In this embodiment, an n-type epitaxial layer 403 is formed on a p-type silicon substrate 401, and a silicon oxide film 405 is selectively formed on the layer 403. Then, a silicon oxide film 407 is formed on the top surface of the n-type epitaxial layer 403, and a silicon nitride film 408 is formed on the entire surface of the resultant structure. The silicon nitride film 408 and the silicon oxide film 407 on that region where an n+-type collector region 410 is to be formed are etched away. A hole 409 is formed which extends from the top surface of the n-type epitaxial layer 403 to the n+-type buried layer 402, with a silicon oxide film 413 formed as a side wall on the side surface of the hole 409. Further, polycrystalline silicon is grown in the hole 409 and an impurity is diffused in the polycrystalline silicon, forming the n+-type collector region 410. Then, a p-type base region 411 and an n+-type emitter region 412 are formed in the same manner as in the third embodiment.

The same comparison as discussed in the section of the third embodiment was made, presenting the current-voltage characteristic as shown in Fig. 26. It is apparent that the leak current was significantly improved as compared with the third prior art. This embodiment, like the third embodiment, can lower the resistance of the n+-type collector region without considering any misfit dislocation in the n+-type collector region. The fourth embodiment can make the gap between the n+-type collector region and the p-type base region even narrower than the first and second embodiments.

## Claims

1. A semiconductor device having a silicon bipolar transistor with an npn junction comprising:
   a hole extending from a top surface of an n-type epitaxial layer formed on an n+-type buried layer into the n-type epitaxial layer; and
   an n+-type collector region formed at a bottom of the hole to be connected to the n+-type buried layer.

2. A semiconductor device according to claim 1, wherein an insulating film is provided on a side surface of the hole.

3. A semiconductor device according to claim 1, further comprising an n+-type polycrystalline silicon film covering the hole and connected to the n+-type collector region.

4. A semiconductor device according to claim 2, further comprising an n+-type polycrystalline silicon film covering the hole and connected to the n+-type collector region.

5. A semiconductor device having a silicon bipolar transistor with an npn junction comprising:

a hole extending from a top surface of an n-type epitaxial layer formed on an $n^+$-type buried layer into an n-type collector region;

an insulating film on a side surface of the hole; and

an $n^+$-type collector region formed in the hole to be connected to the $n^+$-type buried layer.

6. A semiconductor device according to claim 5, wherein the $n^+$-type collector region is formed of single crystalline silicon.

7. A semiconductor device according to claim 5, wherein the $n^+$-type collector region is formed of polycrystalline silicon.

8. A method of fabricating a semiconductor device comprising a formation of an $n^+$-type collector region in an npn silicon bipolar transistor having an $n^+$-type buried layer, an n-type epitaxial layer with a predetermined thickness and a device-isolating region, the collector region formation including the steps of:

forming an insulating film on a top surface of the n-type epitaxial layer, removing the insulating film on that region where the $n^+$-type collector region is to be formed, and etching the n-type epitaxial layer, thereby forming a hole shallower than the thickness of the n-type epitaxial layer; and

doping an n-type impurity from the hole to thereby form the $n^+$-type collector region reaching the $n^+$-type buried layer.

9. A method of fabricating a semiconductor device comprising a formation of an $n^+$-type collector region in an npn silicon bipolar transistor having an $n^+$-type buried layer, an n-type epitaxial layer with a predetermined thickness and a device-isolating region, the collector region formation including the steps of:

forming a first silicon oxide film and a silicon nitride film on a top surface of the n-type epitaxial layer, removing the silicon nitride film and first silicon oxide film on that region where the $n^+$-type collector region is to be formed, and etching the n-type epitaxial layer, thereby forming a hole shallower than the thickness of the n-type epitaxial layer;

forming a second silicon oxide film on a surface of the hole and removing the second silicon oxide film at a bottom of the hole by anisotropic etching; and

doping an n-type impurity from the hole to thereby form the $n^+$-type collector region reaching the $n^+$-type buried layer.

10. A method of fabricating a semiconductor device comprising a formation of an $n^+$-type collector region in an npn silicon bipolar transistor having an $n^+$-type buried layer, an n-type epitaxial layer with a predetermined thickness and a device-isolating region, the collector region formation including the steps of:

forming a first silicon oxide film and a silicon nitride film on a top surface of the n-type epitaxial layer, removing the silicon nitride film and first silicon oxide film on that region where the $n^+$-type collector region is to be formed, and etching the n-type epitaxial layer, thereby forming a hole reaching the n-type buried layer;

forming a second silicon oxide film on a surface of the hole and removing the second silicon oxide film at a bottom of the hole by anisotropic etching;

burying single crystalline silicon in the hole; and

doping an n-type impurity in the single crystalline silicon to thereby form the $n^+$-type collector region.

11. A method according to claim 10, wherein the step of burying the single crystalline silicon in the hole is replaced with a step of burying polycrystalline silicon in the hole.

Fig. 1

506   505        503        502           505   506

504                        501           504

Fig. 2

508      507              510  507      508

Fig. 3

511      512

Fig. 4

Fig. 5

Fig. 6

Fig. 7

Fig. 8

Fig. 9

Fig. 10

Fig. 11

Fig. 12

Fig. 13

Fig. 14

Voltage (Relative Value)

Fig. 15

205  206          203        202          205  206

204                201                204

Fig. 16

208    207    203    213  209    207    208

Fig. 17

214

210

Fig. 18

211          212

Fig. 19

Voltage (Relative Value)

Fig. 20

Fig. 21

Fig. 22

Fig. 23

311    312    310

Fig. 24

Current (Relative Value)

$10^4$

$10^3$

$10^2$

$10^1$

——— Third Embodiment

- - - - - Third Prior Art

0        1        2        3

Voltage (Relative Value)

Fig. 25

Fig. 26

Voltage (Relative Value)